# EUROPEAN PATENT SPECIFICATION

(11) **EP 3 306 437 B1**
(45) Date of publication and mention of the grant of the patent: **28.10.2020**
(21) Application number: 16205422.5
(22) Date of filing: 20.12.2016
(51) Int. Cl.: G06F 1/16, H04M 1/02, H01Q 1/24

(54) **ELECTRONIC DEVICE INCLUDING HOUSING HAVING PARTITIONING PART AND METHOD OF MANUFACTURING THE SAME**
ELEKTRONISCHE VORRICHTUNG MIT GEHÄUSE MIT PARTITIONIERUNGSTEIL UND VERFAHREN ZUR HERSTELLUNG DAVON
DISPOSITIF ÉLECTRONIQUE COMPRENANT UN BOÎTIER AYANT UNE PARTIE DE SÉPARATION ET SON PROCÉDÉ DE FABRICATION

(30) Priority: 04.10.2016 KR 20160127687
(43) Date of publication of application: 11.04.2018
(73) Proprietor: Samsung Electronics Co., Ltd., Gyeonggi-do 16677 (KR)
(72) Inventor: Baek, Seung Chang, 16953 Yongin-si (KR); Kwon, Soon Cheol, 02577 Seoul (KR); Shin, Chang Hyeok, 08364 Seoul (KR); Yoon, Sung Whan, 16491 Suwon-si (KR); Im, Jung Hyun, 13628 Seongnam-si (KR); Hwang, Chang Youn, 18437 Hwaseong-si (KR); Hwang, Han Gyu, 13607 Seongnam-si (KR); Choi, Jong Chul, 16519 Suwon-si (KR)
(74) Representative: Nederlandsch Octrooibureau

(56) References cited:
- US-A1- 2014 126 172
- US-A1- 2014 284 096
- US-A1- 2016 116 948

## Description

### BACKGROUND OF THE INVENTION

### 1. Field of the Invention

The present disclosure relates generally to a partitioning structure of an electronic device.

### 2. Background of the Invention

In recent years, portable electronic devices in various forms, such as smartphones and tablet PCs, have been increasingly distributed. The portable electronic devices may include a communication function. The portable electronic devices may include an antenna related to a communication function.

According to the related art, the portable electronic devices employ a metal housing for the purpose of strength or design. When an antenna pattern is arranged inside the housing of a portable electronic device employing a metal housing, signals cannot be normally transmitted and received.

US 2016/116948 A1 relates to a housing including a metal base and a non-conductive member.

US 2014126172 A1 discloses a method of fabricating a body of a portable electronic device as well as the resulting portable electronic device and its body which facilitate the transmission of radio frequency signals through the body of the portable electronic device. In the context of a method, at least one aperture and, in some instances, a plurality of apertures are defined by laser perforation through a conductive portion of the body of the portable electronic device.

US2014284096 A1 discloses a method of manufacturing a casing of an electronic device including the following steps. A metallic housing is provided, wherein the metallic housing has an inner surface and an outer surface opposite to the inner surface. A plurality of apertures are formed on the inner surface of the metallic housing. A non-conductive layer is formed on the inner surface of the metallic housing, and part of the non-conductive layer is extended into the apertures. The outer surface of the metallic housing is dyed to form the casing of the electronic device. A casing of an electronic device is also provided.

### SUMMARY OF THE INVENTION

Aspects of the present disclosure are provided to address at least the above-mentioned problems and/or disadvantages and to provide at least the advantages described below. The invention is defined as in the appended independent claims. Preferable embodiments are defined in the appended dependent claims. Embodiments described in this disclosure that do not fall within the scope of the claims do not form part of the present invention. Accordingly, an example aspect of the present disclosure provides a housing in which a partitioning part that may be used as an antenna for performing a communication function, that may improve a grip feeling, and that provides an appealing external appearance, and an electronic device including the same.

Other aspects, advantages, and salient features of the disclosure will become apparent to those skilled in the art from the following detailed description, which, taken in conjunction with the annexed drawings, discloses various example embodiments of the present disclosure.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is diagram illustrating an example of a housing of an electronic device according to an example embodiment;
FIG. 2A is a diagram illustrating an example of a first surface of a housing of an electronic device according to an example embodiment;
FIG. 2B is a diagram illustrating an example of a second surface of a housing according to an example embodiment;
FIG. 3A is a diagram illustrating an example of a section of one point of a housing according to an example embodiment;
FIG. 3B is a diagram illustrating an example of a section of another point of a housing according to an example embodiment;
FIG. 4 is a diagram illustrating an example of a process of manufacturing a housing of an electronic device according to an example embodiment;
FIG. 5A is a diagram illustrating parts of a process of manufacturing a housing of an electronic device according to an example embodiment;
FIG. 5B is a flowchart illustrating an example of a method of manufacturing a housing of an electronic device according to an example embodiment;
FIG. 6A is a diagram illustrating an example of an electronic device, to which a housing is applied, according to an example embodiment;
FIG. 6B is a diagram illustrating an example of an electronic device, to which a housing is applied, according to another example embodiment; and
FIG. 7 is a diagram illustrating another example of forming a slit area of a housing of according to an example embodiment.

Throughout the drawings, it should be noted that like reference numbers are used to depict the same or similar elements, features, and structures.

### DETAILED DESCRIPTION OF EMBODIMENTS OF THE PRESENT INVENTION

Various embodiments of the present disclosure may be described with reference to accompanying drawings. Accordingly, those of ordinary skill in the art will recognize that modification, equivalent, and/or alternative on the various embodiments described herein can be variously made without departing from the scope of the appended claims. With regard to description of drawings, similar components may be marked by similar reference numerals.

In the disclosure disclosed herein, the expressions "have", "may have", "include" and "comprise", or "may include" and "may comprise" used herein indicate existence of corresponding features (e.g., elements such as numeric values, functions, operations, or components) but do not exclude presence of additional features.

In the disclosure disclosed herein, the expressions "A or B", "at least one of A or/and B", or "one or more of A or/and B", and the like used herein may include any and all combinations of one or more of the associated listed items. For example, the term "A or B", "at least one of A and B", or "at least one of A or B" may refer to all of the case (1) where at least one A is included, the case (2) where at least one B is included, or the case (3) where both of at least one A and at least one B are included.

The terms, such as "first", "second", and the like used herein may refer to various elements of various embodiments, but do not limit the elements. Furthermore, such terms may be used to distinguish one element from another element. For example, "a first user device" and "a second user device" may indicate different user devices regardless of the order or priority thereof. For example, "a first user device" and "a second user device" indicate different user devices.

It will be understood that when an element (e.g., a first element) is referred to as being "(operatively or communicatively) coupled with/to" or "connected to" another element (e.g., a second element), it may be directly coupled with/to or connected to the other element or an intervening element (e.g., a third element) may be present. In contrast, when an element (e.g., a first element) is referred to as being "directly coupled with/to" or "directly connected to" another element (e.g., a second element), it should be understood that there are no intervening element (e.g., a third element).

According to the situation, the expression "configured to" used herein may be used as, for example, the expression "suitable for", "having the capacity to", "designed to", "adapted to", "made to", or "capable of'. The term "configured to" does not mean only "specifically designed to" in hardware. Instead, the expression "a device configured to" may refer, for example, to a situation in which the device is "capable of' operating together with another device or other components. CPU, for example, a "processor configured to perform A, B, and C" may refer, for example, to a dedicated processor (e.g., an embedded processor including processing circuitry) for performing a corresponding operation or a generic-purpose processor (e.g., a central processing unit (CPU) or an application processor) which may perform corresponding operations by executing one or more software programs which are stored in a memory device.

Terms used in the present disclosure are used to describe various example embodiments and are not intended to limit the scope of the present disclosure. The terms of a singular form may include plural forms unless otherwise specified. Unless otherwise defined herein, all the terms used herein, which include technical or scientific terms, may have the same meaning that is generally understood by a person skilled in the art. It will be further understood that terms, which are defined in a dictionary and commonly used, should also be interpreted as is customary in the relevant related art and not in an idealized or overly formal manner unless expressly so defined herein in various example embodiments of the present disclosure. In some cases, even if terms are defined in the disclosure, they may not be interpreted to exclude embodiments of the present disclosure.

An electronic device according to various example embodiments of the present disclosure may include at least one of smartphones, tablet personal computers (PCs), mobile phones, video telephones, e-book readers, desktop PCs, laptop PCs, netbook computers, workstations, servers, personal digital assistants (PDAs), portable multimedia players (PMPs), Motion Picture Experts Group (MPEG-1 or MPEG-2) Audio Layer 3 (MP3) players, mobile medical devices, cameras, wearable devices (e.g., head-mounted-devices (HMDs), such as electronic glasses), an electronic apparel, electronic bracelets, electronic necklaces, electronic appcessories, electronic tattoos, smart watches, and the like, but are is limited thereto.

According to another example embodiment, the electronic devices may be home appliances. The home appliances may include at least one of, for example, televisions (TVs), digital versatile disc (DVD) players, audios, refrigerators, air conditioners, cleaners, ovens, microwave ovens, washing machines, air cleaners, set-top boxes, home automation control panels, security control panels, TV boxes (e.g., Samsung HomeSync™, Apple TV™, or Google TV™), game consoles (e.g., Xbox™ or PlayStation™), electronic dictionaries, electronic keys, camcorders, electronic picture frames, or the like, but are not limited thereto.

According to another example embodiment, the electronic device may include at least one of medical devices (e.g., various portable medical measurement devices (e.g., a blood glucose monitoring device, a heartbeat measuring device, a blood pressure measuring device, a body temperature measuring device, and the like)), a magnetic resonance angiography (MRA), a magnetic resonance imaging (MRI), a computed tomography (CT), scanners, and ultrasonic devices), navigation devices, global positioning system (GPS) receivers, event data recorders (EDRs), flight data recorders (FDRs), vehicle infotainment devices, electronic equipment for vessels (e.g., navigation systems and gyrocompasses), avionics, security devices, head units for vehicles, industrial or home robots, automatic teller's machines (ATMs), points of sales (POSs), or internet of things (e.g., light bulbs, various sensors, electric or gas meters, sprinkler devices, fire alarms, thermostats, street lamps, toasters, exercise equipment, hot water tanks, heaters, boilers, and the like), or the like, but are is limited thereto.

According to another example embodiment, the electronic devices may include at least one of parts of furniture or buildings/structures, electronic boards, electronic signature receiving devices, projectors, or various measuring instruments (e.g., water meters, electricity meters, gas meters, or wave meters, and the like), or the like, but are not limited thereto. In the various example embodiments, the electronic device may be one of the above-described various devices or a combination thereof. An electronic device according to an example embodiment may be a flexible device. Furthermore, an electronic device according to an example embodiment may not be limited to the above-described electronic devices and may include other electronic devices and new electronic devices according to the development of technologies.

Hereinafter, an electronic device according to the various example embodiments may be described with reference to the accompanying drawings. The term "user" used herein may refer to a person who uses an electronic device or may refer to a device (e.g., an artificial intelligence electronic device) that uses an electronic device.

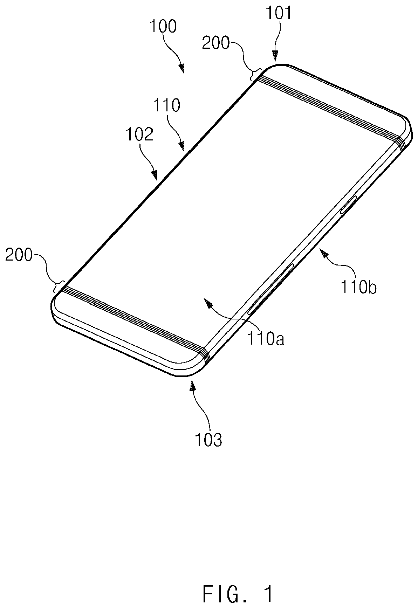

FIG. 1 is a diagram illustrating an example of a housing of an electronic device according to an example embodiment.

Referring to FIG. 1, the housing 110 of the electronic device 100 may, for example, include an upper part 101, an intermediate part 102, and a lower part 103. Further, the housing 110 may include a main body 110a and at least one side wall 110b arranged at a periphery of the main body 110a. The main body 110a, for example, may have a polygonal shape (for example, a rectangular shape), a substantially circular shape, or a substantially elliptical shape, and may have a specific thickness. The side wall 110b may be formed at the periphery of the main body 110a, and may have a specific height while having a specific angle (for example, the right angle) from the main body 110a. When the main body 110a has a rectangular shape, four side walls 110b may be formed at four peripheries of the main body 110a, respectively. Portions at which the side walls meet each other may, for example, be rounded.

According to an example embodiment, the housing 110 may include a slit area 200 that is arranged between the upper part 101 and the intermediate part 102 of the housing 110 and a slit area 200 that is arranged between the intermediate part 102 and the lower part 103 of the housing 110. The slit areas 200 may has the same or similar structures, except for the locations thereof, as they may be formed through the same or similar processes.

Although it has been illustrated in the above description and FIG. 1 that the slit areas 200 are arranged to be close to an upper end and a lower end of the housing 110, respectively, the present disclosure is not limited thereto. For example, the housing 110 may include only one slit area 200. Further, the housing 110 may further include two or more slit areas. For example, the slit area 200 may be further provided at the intermediate part 102 of the housing 110. Further, although it has been illustrated that the slit areas 200 extend from the left side to the right side of the housing 110 extending longitudinally, the present disclosure is not limited thereto. For example, according to an example embodiment, at least one slit area 200 may be formed in a direction (a longitudinal direction of the drawing) of a long axis of the housing 110. According to various example embodiments, although it has been illustrated that the slit area 200 is formed in the main body 110a that defines front and rear surfaces of the housing 110, the present disclosure is not limited thereto. According to an example embodiment, the slit area 200 may be formed at least one site of the side walls 110, as well as in the main body 110a. For example, as illustrated in FIG. 1, the slit area 200 may be formed on a side wall situated at the upper end of the housing 110 or a side wall situated at the lower end of the housing 110.

The above-mentioned slit area 200 of the present disclosure may include a slit (or a partitioning part) having a specific width of, for example, not more than a given size (for example, 1 mm). Because the slit area 200 is formed such that the width of the slit has not more than a specific size, rail parts that are used as antennas may be implemented thinner. The slit area 200, for example, may be formed using computer numerical control (CNC) machining. While the slit area 200 may be formed through laser machining or CNC machining, produced metal dust may be almost completely removed by sequentially machining front and rear surfaces of the main body 110a. Further, because a slit filling part is provided through an injection-molding operation after the slit having a specific depth is formed in the main body 110a when the slit area 200 is formed, deformation of the rail parts or slits may be prevented and/or reduced by allowing at least a portion of an inner side of the main body 110a to support the rail parts.

The slit area 200 may include at least one slit having a width of not more than a given size (for example, 1 mm). Further, the slit area 200 may include at least two slits having a width of not more than a given size. Because a plurality of slits are formed, the housing 110 may include at least one rail part that is defined (or distinguished) by the slits. An appealing shape in design may be achieved and a stable grip feeling may be provided when the housing 110 is gripped, by arranging the plurality of slits or the plurality of rail parts in a specific pattern. Further, an improved signal transmitting/receiving function without or having reduced noise due to metal dust may be provided when a communication function is performed through the rail parts, by providing the rail parts, from which metal dust is substantially and/or completely removed. According to an example embodiment, a bonding force between the rail parts and a bonding force between the rail parts and the peripheral housing may be increased due to the gaps between the rail parts, by making the gaps between the rail parts narrow by using the slits of not more than a specific size and forming slit filling parts in the slits. Further, a bonding force between the rail parts may be increased by providing a bonding layer together with the slit filling parts.

The electronic device 100 including the housing 110, for example, may include a display at least a portion of which is exposed to the outside through an opening formed in a first surface of the housing 110 such that the display outputs a screen based on execution of a function, a processor that processes signals related to driving of the display, a memory that stores data, a printed circuit board on which the processor and the memory are mounted, and a battery that provides electric power related to driving of the electronic device. Further, the electronic device may include a camera that collects images, at least one sensor that collects sensor information related to a motion of the electronic device, and at least one communication interface that performs communication by using at least one rail part included in the slit area 200. The communication interface, for example, may include various communication circuitry, such as, for example, and without limitation, a wireless communication chip that performs communication based on a mobile communication base station, a communication chip that supports communication through a wireless access point (AP), a magnetic secure transmission (MST) communication chip or a near field communication (NFC) communication chip that performs short range communication such as electronic payment.

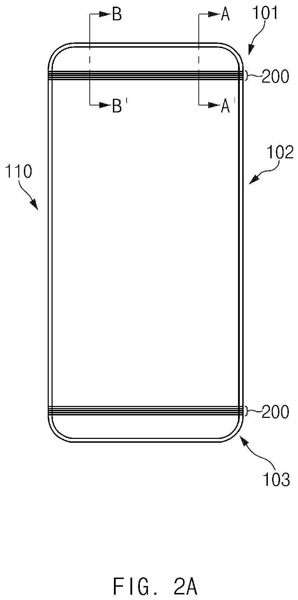

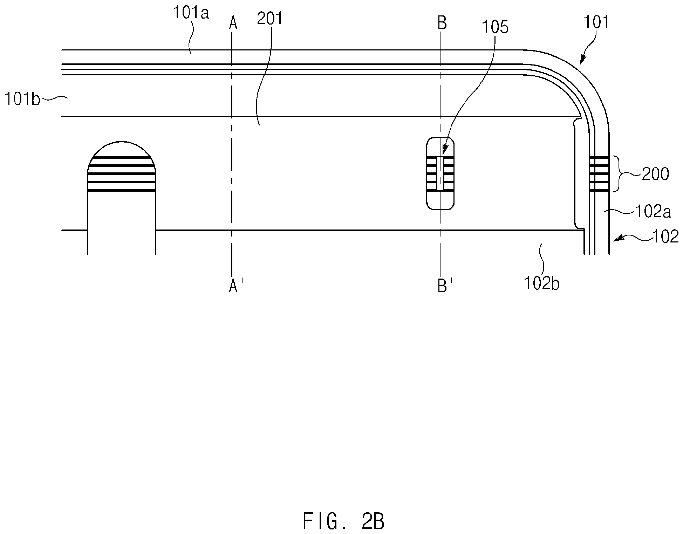

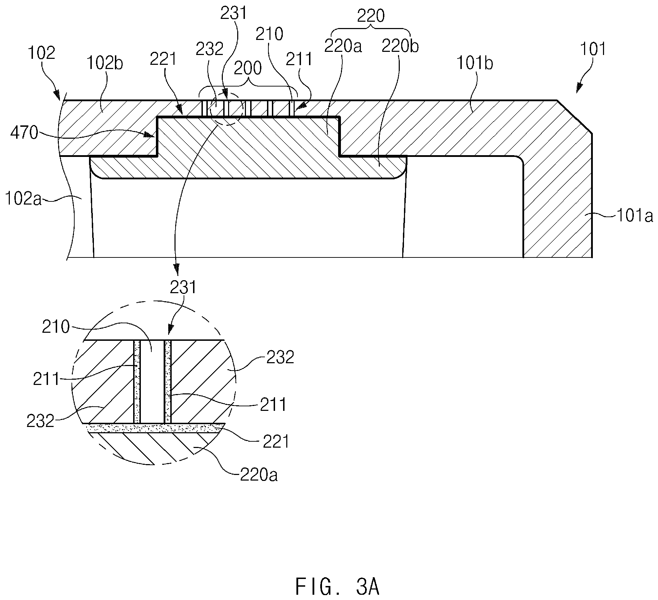

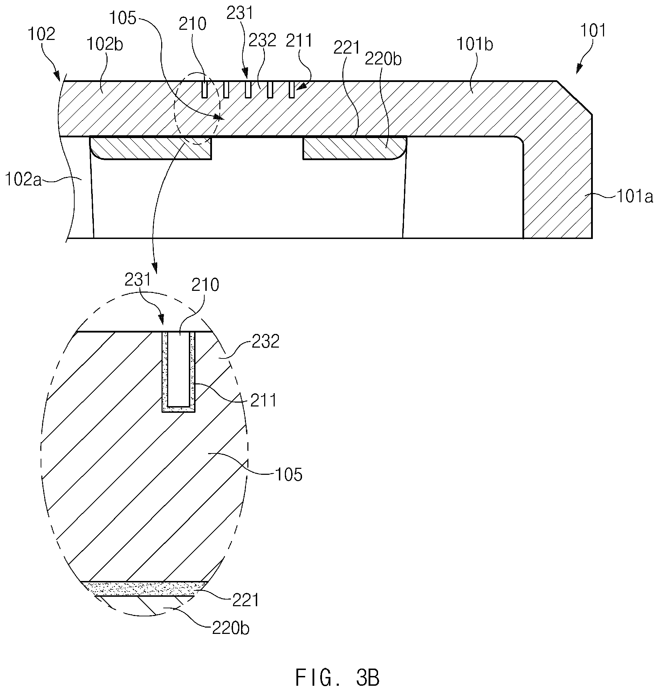

FIG. 2A is a drawing illustrating an example of a first surface of a housing of an electronic device according to an example embodiment. FIG. 2B is a diagram illustrating an example of a second surface of a housing according to an example embodiment. FIG. 3A is a diagram illustrating an example of a section of one point of a housing according to an example embodiment. FIG. 3B is a diagram illustrating an example of a section of another point of a housing according to an example embodiment. For example, FIG. 3A is a view illustrating a section A-A' of a portion of the portion of FIG. 2A or FIG. 2B, at which a slit area is formed, and FIG. 3B is a view illustrating a section B-B' of a slit area of the portion of FIG. 2A or 2B, in which a rib is formed on an inner surface thereof.

Referring to FIGS. 2A to 3A, in the housing 110 according to an example embodiment, an upper side wall 101a of the housing 110 may be arranged to have a specific angle with an end 101b (one side of the main body 110a) of the upper part 101 of the housing 110. The slit area 200 may be formed between the upper part 101 and the intermediate part 102 to have a specific width. The intermediate part 102 of the housing 110, for example, may include an end 102b of the intermediate part 102 of the housing 110 and a side wall 102a of the intermediate part 102 of the housing 110 that has a specific angle with the end 102b of the intermediate part 102 of the housing 110. The side wall 101a of the upper part 101 of the housing 110, for example, may include a side wall situated in an upper part of the above-described side wall 110b, and the side wall 102b of the intermediate part 102 of the housing 110 may include at least one of the left and right side walls, which are situated in the intermediate part 102, of the side walls 110b.

The slit area 200 may be arranged between the end 101b of the upper part 101 of the housing 110 and the end 102b of the intermediate part 102 of the housing 110 and over the side wall 102a of the intermediate part 102 of the housing 110. According to various example embodiments, as described above, the slit area 200 formed at a lower end of the housing 110 (for example, an opposite side of the man body 110a) may be arranged between the lower part 103 and the intermediate part 102 of the housing 110. The slit area 200 may include a plurality of slits 231. In relation to the number of the slits 231, although the drawing illustrates five slits, the number of slits 231 may be changed based on a change in design manner or the number of the communication modules that will be applied. The widths of the slits 231, for example, may be in a range of 0.01 mm to 1 mm or in a range of about 0.01 mm to 1 mm. The depths of the slits 231, for example, may be in a range of 0.1 mm to 6.0 mm or in a range of about 0.1 mm to 6.0 mm. As the slits 231 are formed, at least one rail part 232, at least a portion of which is spaced apart from the upper part 101 and the intermediate part 102 of the housing 110, may be arranged. The widths and areas of the rail parts 232 may be determined by the gaps between the slits 231 and the depths of the slits 231. The widths and areas of the rail parts 232, for example, may be determined depending on a communication frequency band of a communication module that will be used. The rail parts 232 may be connected to each other based on at least one rib 105 as illustrated in FIGS. 2B and 3B. According to various embodiments, the slit area 200 may not include a rib 105 as illustrated in FIGS. 2A and 3A. In this case, the rail parts 232 may be separated from each other by the slits 231, and may be connected to each other by a slit filling part 210 and a first bonding layer 211. Accordingly, when the slit area 200 does not include a rib 105, the rail parts 232 may be electrically isolated from each other, and may be arranged while the slit filling part 210 and the first bonding layer 211 being interposed therebetween.

A first bonding layer 211 and a slit filling part 210 may be arranged inside the slit 231. According to an example embodiment, after a recess corresponding to the slit 231 is formed in the housing 110, the housing 110 may be immersed in a container filled with a bonding material and be dried to form the first bonding layer 211. After the first bonding layer 211 is formed, the slit filling part 210 may be formed in the slit 231 through, for example, an injection-molding operation using a thermoplastic material.

According to various example embodiments, a recess 470 may be formed inside the housing 110 through, for example, CNC machining. The recess 470 may be formed for arrangement of various device elements (for example, a communication module, a printed circuit board, a camera module, and a sensor) embedded in the housing 110. As the recess 470 is formed, some areas of the rail parts 232 may be separated from each other. As illustrated, at least one support part 220 may be arranged in an area of an inside of the housing 110 including the recess 470. The support part 220, for example, may include a first support part 220a that fills the recess 470, and a second support part 220b that extends from the end of the housing 110 by a specific height while extending from the first support part 220a. A second bonding layer 221 may be arranged between the support part 220 and the area including the recess 470. Because the support part 220 is formed after the slit filling part 210 is formed, the second bonding layer 221 may be arranged between the slit filling part 210 and the support part 220. Further, after the first bonding layer 211 is formed on an inner wall (or an inner wall of the rail part 232) of the slit 231, a lower surface of the slit filling part 210 may be exposed to the inside of the housing 110 through the recess 470 of the housing 110 if the bottom of the slit 231 is removed such that the slit 232 may vertically pass as the recess 470 is formed. The slit filling part 210 and the support part 220 may be connected to each other while the support 220 is formed in the recess 470. When the second bonding layer 221 is formed inside the housing 110 including the recess 470 before the support part 220 is formed, the slit filling part 210 and the first bonding layer 211 may be connected to one surface of the second bonding layer 221. The support part 220 may be formed at at least one of an end of the housing 110 and an area of the side wall of the housing 110.

Referring to FIGS. 2A to 3B, the housing 110 according to an example embodiment may include an upper part 101 and an intermediate part 102, and may include a slit area 200 arranged between the upper part 101 and the intermediate part 102 of the housing 110. As illustrated, the slit area 200 may include a plurality of slits 231 and a plurality of rail parts 232, and may include a rib (or a metal rib) in which the slits 231 and the rail parts 232 are formed. The rib 105, for example, may be a portion of the housing 110. According to an example embodiment, the rib 105 may be provided by partially forming a recess 470 of a specific size inside the housing 110 after the slits 231 are formed on the outside of the housing 110. The rib 105 may function to fix the rail parts 232 that are independently arranged by the slits 231. Further, the rib 105 may be formed in a process of machining an inside of a slit structure after the slit structure is formed. The rib 105 may support the rail parts 232 to prevent deformation of the rail parts 232 in a process of forming an inner structure and machining an outer shape (for example, a process of removing a portion of the inner structure) after the inside of the slit structure is machined. Because ends of the rail parts 232 are fixed by the rib 105, distortion or deviation of the rail parts 232 or deformation of gaps between the rail parts 232 (or deformation of the gaps between the slits 231) may be restrained while only the slit filling parts 210 are left in the slit structure. Further, the rib 105 may be electrically connected to the rail parts 232 to function as a signal line or a pad that grounds the rail parts 232 to the upper part 101 or the intermediate part 102 of the housing 110 (or the lower part 103 or the intermediate part 102 of the housing 110 when the slit area 200 is formed in the lower part 103 of the housing 110). A portion of the support part 220 (for example, the second support part 220b) (or a non-conductive inner structure) may be arranged on an inner surface of the housing 110, on which the rib 105 is formed. Although it has been illustrated in the above description that one rib 105 is formed on the right upper side of the housing 110, the present disclosure is not limited thereto. For example, a plurality of ribs 105 may be arranged based on a design scheme. Further, at least one rib 105 may be removed in a process of machining the housing 110 after a side wall 110b (for example, a side wall 102a of the intermediate part 102 of the housing 110) associated with the slit area 200 is formed so that a slit area 200 that does not include the rib 105 may be provided. A first bonding layer 211 and a slit filling part 210 may be arranged inside the slit 231 in which the rib 105 is formed.

As described above, various example embodiments may include a housing 110, at least an area (for example, a side surface (upper, lower, left, and right) or a rear surface) of which, except for an opening area in which a display is arranged, includes a metal, at least one micro-slit 231 provided on one side of the housing 110 through grooving, and a partitioning band in which a slit filling part 210 formed by filling the slit 231 with a non-conductive material (or a thermoplastic non-conductive material). The slit area 200 of the housing 110 according to the present disclosure may be provided through CNC machining or laser machining, and a slit 231 of an excellent straightness may be formed when only CNC machining is used. Further, the slit filling part 210 may be stably formed in the housing 110 even in an injection-molding process of high temperature and high pressure by fixing at least some areas of the rail parts 232 partitioned by the slits 231 with the rib 105. Further, the housing 110 of the present disclosure may secure a joining force between the rail parts 232 based on the sealing property of the slit filling part 210 and the bonding layers. In the process of forming the main body before the above-mentioned slit 231 is formed, for example, a metal material may be pressed or forged.

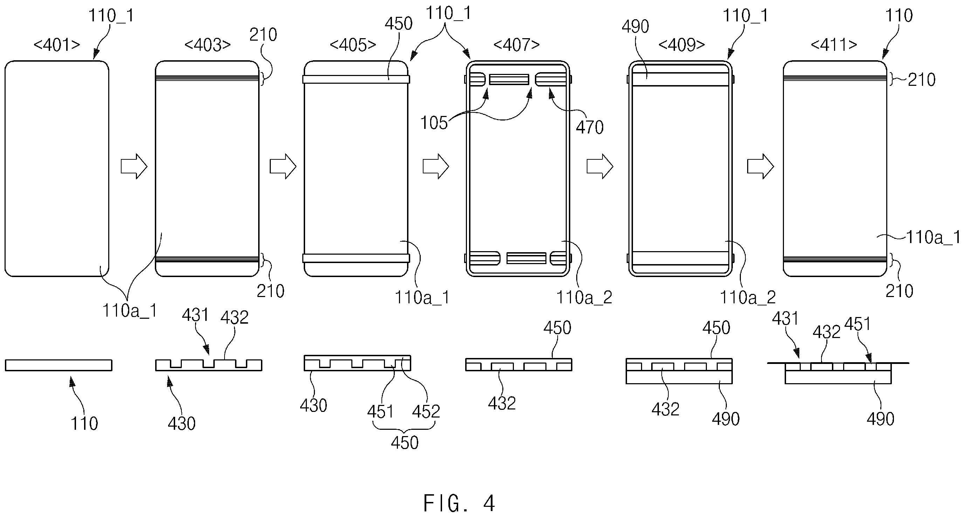

FIG. 4 is a diagram illustrating an example process of manufacturing a housing of an electronic device according to an example embodiment.

Referring to FIG. 4, in relation to the manufacturing of the housing, in operation 410, a basic housing 110_1 according to an example embodiment may be provided. The basic housing 110_1 may include a main body (for example, the main body 110a) and a plurality of side walls (for example, the side walls 110b) that extend from a periphery of the main body while having a specific angle (for example, the right angle) from the main body. For example, the side walls of the basic housing 110_1 may have a height that is relatively large as compared with before the outer outsides of the side wall are formed. Accordingly, the side walls of the basic housing 110_1 may have a height that is larger as compared with before the outer sides of the side walls are formed, after the outer sides of the side walls are formed. The above-mentioned basic housing 110_1, for example, may have a seating part having a specific size on an inside thereof, based on the main body and the side walls. Device elements (for example, a printed circuit board, a display, a battery, and a camera) of the electronic device may be seated on the seating part. The drawing of state 401 illustrates an outer surface 110a_1 of the main body. The basic housing 110_1 may, for example, be provided through pressing, forging, or full CNC machining, or the like, but is not limited thereto.

In operation 403, a slit 431 may be machined on one side (for example, an outer side 110a_1 of the main body and the side walls) of the basic housing 110_1. For example, a plurality of slits 431 disposed in a first direction (for example, a transverse direction) may be arranged on one side of the basic housing 110_1. The slits 431 may be changed depending on the number of rail parts 432 that are to be formed. The widths of the slits 431, for example, may be in a range of 0.01 mm to 1 mm or in a range of about 0.01 mm to 1 mm. As illustrated, the slit area 200 in which the slits 431 are arranged may include a form in which a plurality of slits 431 or a plurality of rail parts 432 are arranged at a specific interval. The slit area 200, for example, may be arranged at a specific location of an upper part or a lower part of the basic housing 110_1. The location of the slit area 200 may be changed depending on a location of a communication interface that is to be arranged. According to an example embodiment, while the slit 431 is formed, at least a portion of the produced metal dust may be inserted into the slit 431. According to an example embodiment, the slits 431 arranged in the slit area 200 may be implemented to have the same size width and tolerance on the inner and outer sides thereof, thereby improving a performance of the antenna. The depth of the slit 431 may be small in a specific region and may be large in another specific region within a range of 0.1 mm to 6 mm (for example, 0.1 mm to 2.0 mm) or in a range of about 0.1 mm to 6 mm. Fused metal residuals or metal powder may be formed in the slit 431.

In operation 405, a slit structure 450 may be arranged on an area (for example, at least an area of an outer surface 110a_1 of the main body and the side walls) in which the slit 431 is formed. The slit structure 450, for example, may be formed through injection-molding by using a thermoplastic and non-conductive material. In relation to the formation of the slit structure 450, because a portion of a resin (or an injection-molded product) are introduced into the slit 431 and a remaining portion thereof is formed on the area, in which the slit 431 is arranged, to have a specific thickness, the slit structure 450 may include a slit support 452 and a slit filling part 451. In this regard, the slit structure 450 may be formed by fixing the basic housing 110_1 having the slit 431 to a mold and injecting an injection-molding material to a location of the slit 431 to provide a specific shape and cool the molded product. For example, a color of the slit structure 450 may include at least one of various colors. Additionally, the slit structure 450 of the present disclosure may reinforce strength by adding an inorganic filler to a thermoplastic resin. In the above-mentioned slit structure 450, when the non-conductive thermoplastic resin and the slit 431 need to be attached to each other with a string coupling force, the strength of the product may be improved and the quality of the product may be satisfactory. Accordingly, before the slit structure 450 is formed and after the slit 431 is machined, a bonding layer may be formed in the slit area 200 of the basic housing 110_1 having the slit 431. In relation to the formation of the bonding layer, the bonding layer may be formed on an inner wall of the slit 431 by washing a surface of the slit area 200, activating the slit area 200, producing a bonding layer (for example, producing a TRI bonding film, for example, producing a bonding film through immersion of the slit area in a bonding material solution), and washing and drying the slit area. Thereafter, the slit structure 450 may be formed by injecting the thermoplastic resin into an interior space of the slit 431 having the bonding layer.

In operation 407, a recess 470 may be partially formed on an inner area (for example, an inner surface 110a_2 of the main body and the side walls) of the basic housing 110_1. At least one area of the recess 470 may be provided in an area in which the device elements (for example, a camera module and a communication interface) of the electronic device are arranged. As the recess 470 is formed, the slit 431 may extend from the front surface to the rear surface of the basic housing 110_1. Accordingly, the metal dust or powder in the slit 431 may be removed through the recess 470. The recess 470 may include at least a portion of the area in which the slits 431 are arranged. According to an example embodiment, the recesses 470 formed in the slit area 200 may have a gap therebetween and the gap of the recesses 470 may correspond to the metal rib 105. In operation 409, the metal rib 105 may function to firmly support the slit 431 while the inner structure 490 (for example, the support part 220) is formed on the slit 431. The metal rib 105 may be finally removed in an outside forming process. According to various embodiments, at least a portion of the metal rib may be formed in a side wall area (for example, a side wall area in which the slit area 200 is formed) of the intermediate part of the basic housing 110_1 to fix the rail parts 432 while the slit filling part 451 is formed. Thereafter, the metal rib may be removed while the outer side of the basic housing 110_1 is machined.

In operation 409, the inner structure 490 may be formed in an area (for example, at least an area of the inner surface 110a_2 of the main body and the side walls) including the recess 470 formed on the inside of the basic housing 110_1. The inner structure 490 may be formed in an area in which the recess 470 and the metal rib 105 are arranged. In this regard, the inner structure 490 may be formed by fixing the basic housing 110_1 to a mold and injecting a resin corresponding to the inner structure 490 for injection molding.

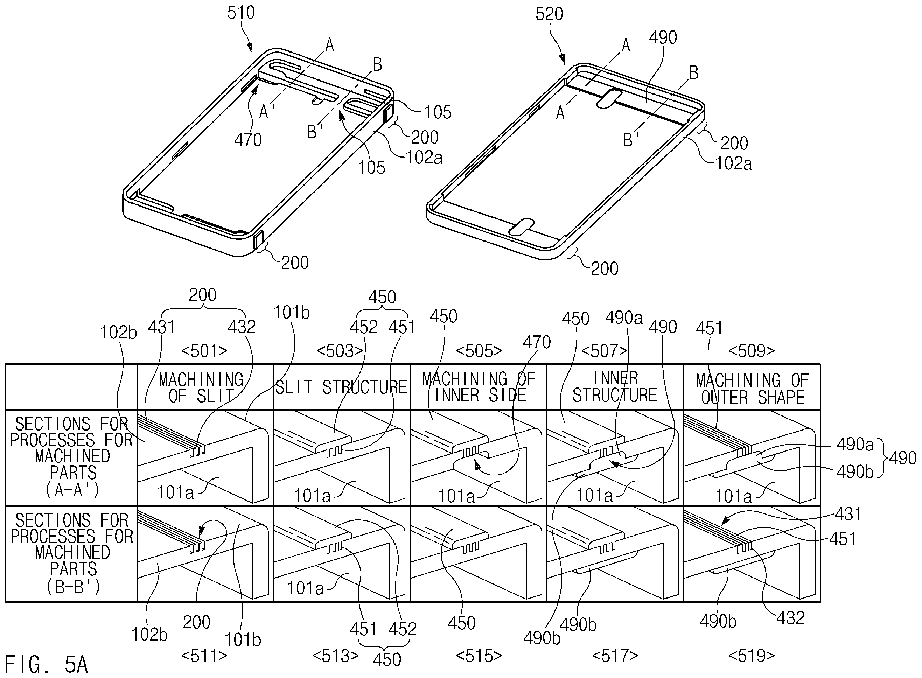

In operation 411, an outer side of the basic housing 110_1 may be machined such that at least a portion of the slit filling part 451 is exposed to the outside, by removing the slit support part 452 of the slit structure 450. When the outer side of the basic housing 110_1 is machined, the housing 110 may be provided such that the height of the side walls of the basic housing 110_1 is changed. The drawing illustrates an outer surface 110a_1 of the main body and the side walls of the housing 110. In response to the removal of the slit support part 452, the outer surface 110a_1 of the main body and the side walls that has been covered by the slit support part 452 may be exposed to the outside. The slits 431 may be separated from each other by separate metal pieces and may be formed independently so that components may be mounted and a performance of the antenna may be secured, or all the slits may be connected to the inside of the product such that a strength of the product may be secured or the performance of the antenna may be secured according to occasions. FIG. 5A is a diagram illustrating parts of a process of manufacturing a housing of an electronic device according to an example embodiment.

Referring to FIG. 5A, the housing 510 before the outer side thereof is machined may include a side wall that is higher than the housing 520 after the outer side thereof is machined. The housing 510 may correspond to the basic housing 110_1 described in FIG. 4. After the inner structure of the housing 510 is injection-molded, the housing 520 may be provided such that at least a portion of the height of the side wall 102a may be machined to be reduced. The housing 520 may correspond to the housing 110 described in FIG. 4. In relation to a process of manufacturing the housing of the present disclosure, in operation 510, a slit area 200 that includes at least one slit 431 in the housing 510 may be formed. At least a portion of the slit 431 may be arranged between the end 101b of the upper part 101 of the housing 110 and the end 102b of the intermediate part 102 of the housing 110. Further, at least a portion of the slit 431 may be formed in the side wall 102a of the intermediate part 102 of the housing 110. At least a portion of the slit 431, for example, may be formed, for example, through CNC machining or laser machining, or the like, but is not limited thereto.

The slit 431, for example, may be formed in the main body and the side walls of the housing 510. Then, the slit 431 may extend from the left side to the right side of the main body, and may be formed on the side wall to have a specific height such that the rib 105 is provided on the side wall 102a. The rib 105 formed in the side wall 102a may be removed while the housing 520 is formed through machining of the outer side of the housing 520 such that an end of the slit 431 is exposed to the outside through the upper surface of the side wall 102a.

As a plurality of slits 431 are formed, at least one rail part 432 may be provided in the slit area. A portion of the housing 510 may include an end 101b of the upper part 101 of the housing 110, an end 102b of the intermediate part 102 of the housing 110, and a first side wall 101a of the upper part 101 of the housing 110. Before an outside of the housing 110 is machined, in operations 501 to 507, the side wall 101a of the upper part 101 of the housing 110 may have a specific height, and the side wall 101a of the upper part 101 of the housing 110 of operation 509 may be formed high after the outside of the housing 110 is machined. In operation 501, a first section A-A' (for example, an area in which a metal rib 105 is not formed but a recess is formed in the inner bottom part) and a second section B-B' (for example, an area in which the metal rib 105 is formed) may correspond to the same section.

In operation 503, the housing 510 having at least one slit 431 may be primarily injection-molded such that the slit structure 450 is formed. The slit structure 450, for example, may include a slit filling part 451 that is formed between a plurality of slits 431 and a slit support part 452 that is arranged to cover the slit areas. According to various example embodiments, a process of forming a bonding layer in the slit 431 before the slit structure 450 is formed may be further provided. In relation to the formation of the bonding layer, a bonding layer may be formed via processes of washing a surface of the slit 431, activating the slit 431, producing a bonding film (TRI), hot-water rinsing the slit 431, and drying the slit 431. As illustrated, in the process of forming the slit structure 450, the first section A-A' may include both the slit filling part 451 and the slit support part 452. Because the whole slit structure 450 is formed in the slit area 200, the second section B-B' may have substantially the same form as the first section A-A' in operation 503.

In operation 505, at least one recess 470 may be formed on an inside of the housing 510 through machining of the inside of the housing 510. The size and shape of the recess 470 may be changed depending on the types and shapes of the device elements of the electronic device. Because the recess 470 is formed on an inside of the housing 510, the bottom of the slit 431 may be exposed to the inside of the housing 510 through the recess 470. Because the slit filling part 451 is formed in the slit 431, an end of the slit filling part 451 and ends of the rail parts 432 may be exposed to the inside of the housing 510. In operation 505, the first section A-A' may include a slit support part 452, a slit filling part 451 that is arranged under the slit support part 452, and a recess 470 through which the slit filling part 451 (or the slit 431 or the rail part 432) is exposed. Because the second section B-B' does not have a recess 470 but is formed in the form of a metal rib 105, it may have the same form as the second section of operation 503.

In operation 507, at least one inner structure 490 may be formed in the housing 510. The inner structure 490, for example, may be formed on an inside of the housing 510 having the slit area 200. At least a portion of the inner structure 490 may correspond to a structure that is introduced into the recess 470 to fill the recess 470, and a remaining portion thereof may correspond to a structure that covers the metal rib 105. As a whole, the outer surface of the inner structure 490 may be formed uniformly or to be uneven according to the form of a mold. In this case, as illustrated, the first section A-A' may include the slit support part 452 and the slit filling part 451 (or the slit 431 or the rail parts 432) from the upper side to the lower side (or in a direction from the outside to the inside of the housing 510), and the inner structure 490, for example, may include a first support part 490a (for example, the first support part 220a) and a second support part 490b (for example, the second support part 220b). As illustrated, the second section B-B', in which the recess 470 is not formed and the metal rib 105 is formed, may include a slit support 452, a slit filling part 451, and a second support part 220b from the upper side to the lower side.

According to various example embodiments, a bonding layer may be formed on an inner wall (or a surface of the housing having the recess 470) of the recess 470. Accordingly, after a bonding layer is formed on the inner wall of the recess 470, the inner structure 490 may be firmly bonded to the inner wall of the recess 470 and the inside of the housing 510 along the bonding layer. In this regard, a process of forming a bonding layer in the housing 510 having the recess 470 may be performed. For example, the bonding layer may be formed by performing a washing and drying process after the housing 510 having the recess 470 is immersed in the bonding solution or the bonding solution is applied to the inner wall of the recess 470.

In operation 509, the outer side of the housing 510 may be machined. When the outer side of the housing 510 is machined, the height of the side wall of the housing 510 may be machined to have a specific height. Accordingly, the height of the side wall 101a of the upper part 101 of the housing 510 in the first section A-A' may be smaller than the height of the side wall 101a before the machining of the outer side of the housing 510. The second section B-B' may have the same form as the previous form (the form of operation 507), except for the side wall 101a of the upper part 101 of the housing 510 that is lower than the side wall 101a substantially before the outer side of the housing 510 is machined (for example, operation 507). Further, when the outer side of the housing 510 is machined, the slit support part 452 may be removed. Accordingly, as in the first section A-A', upper ends of the slits 431, the slit filling parts 451, and the rail parts 432 may be exposed from the outer surface of the housing 520, and lower ends of the slits 431, the slit filling parts 451, and the rail parts 432 may be coupled to the inner structure 490 (for example, the first support part 490a and the second support part 490b) on an inner surface of the housing 520. Further, as in the second section B-B', the lower ends of the slits 431, the slit filling parts 451, and the rail parts 432 may be coupled to the second support part 490b. As described above, the bonding layer may be arranged on the coupling surface.

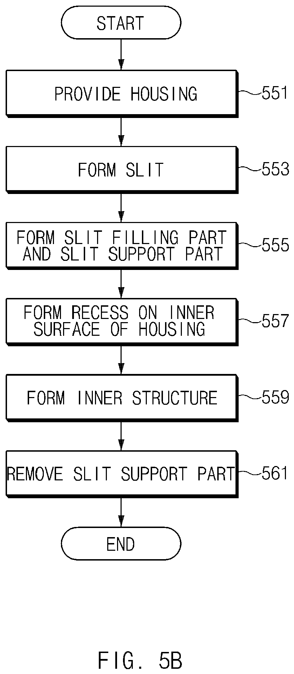

FIG. 5B is a flowchart illustrating an example method of manufacturing a housing of an electronic device according to an example embodiment.

Referring to FIG. 5B, in relation to the method of manufacturing a housing of an electronic device, in operation 551, a housing may be provided. The housing may include a main body formed on a first surface, and at least one side wall formed on a second surface that is different from the first surface at a periphery of the main body.

In operation 553, a slit forming process may be performed. At least one slit having a specific depth (for example, in a range of 0.1 mm to 6 mm) and a specific width (e.g., in a range of 0.01 mm to 1 mm) may be formed at least one surface of the housing. For an excellent straightness or a straightness of not less than a reference value, CNC machining may be performed when the slit is formed.

In operation 555, a process of forming a slit filling part and a slit support part may be performed. First, a slit filling part is formed in the slit and then a slit support part connected to the slit filling part and formed on at least one surface of the housing to have a specific thickness may be formed. In relation, an injection-molding material may be injected into a mold to be injected between the slits, and then the slit support part having a specific height and a specific area may be formed to cover a slit area.

In operation 557, a recess forming process may be performed. In this process, at least a portion of the slit may extend from an outer surface to an inner surface of the housing. According to an example embodiment, a recess may be partially formed in the slit area of the inner surface of the housing such that a rib is formed. When a separate rib is not formed, a recess that includes the whole area in which the slit is formed may be provided.

In operation 559, an inner structure forming process may be performed. The inner structure may be provided at at least a portion of the inner surface of the housing including the recess through injection molding.

In operation 561, a slit support part removing process may be performed. While the slit support part is removed, the rib may function to fix the slits or the rail parts that defines the slits. Further, while the slit support part is removed, the slit filling parts filled in the slits may prevent deformation of the rail parts.

According to an example embodiment of the present disclosure, the method of manufacturing a housing of an electronic device according to an example embodiment may include providing a housing that comprises a main body formed on a first surface, and at least one side wall formed at a periphery of the main body on a second surface different from the first surface, forming at least one silt having a specific depth and a specific length on at least one surface of the housing, filling a slit by forming a slit filling part in the slit and forming a slit support part connected to the slit filling part and formed on at least one surface of the housing to have a specific thickness, forming at least one recess on an inner surface of the housing corresponding to an area in which the slit is formed such that at least a portion of the slit extends from an outer surface of the housing to an inner surface of the housing, forming an inner support structure at least a portion of an inner surface of the housing comprising the recess, and removing the slit support part.

According to various example embodiments, the forming of the recess may include forming a rib that connects rail parts partitioned by the slit, by partially forming the recess.

According to various example embodiments, the forming of the slit may include forming a rib which defines a slit such that the slit extends at a height of a side wall of the housing and a remaining portion of which connects rail parts partitioned by the slit.

According to various example embodiments, the method may further include forming a first bonding layer on inner walls of the rail parts partitioned by the slit after the slit is formed.

According to various example embodiments, the method may further include forming a second bonding layer on an inner wall of the housing after the recess is formed.

According to various example embodiments, the method of manufacturing a housing of an electronic device according to an example embodiment may include a process of preparing a housing that includes a main body, and at least one side wall arranged at a periphery of the main body, a process of forming at least one slit having a specific depth on an outer surface of the housing, a process of injecting a resin to an area including the slit to form a slit structure, a process of forming a recess on an inner wall of the housing corresponding to a location of the slit structure, and a process of forming an inner support structure that covers the recess and a portion of the inner wall of the housing.

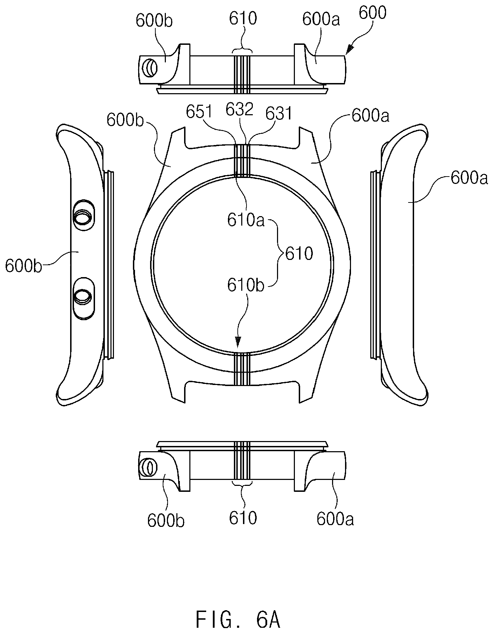

FIG. 6A is a diagram illustrating an example of an electronic device, to which a housing is applied, according to an example embodiment.

Referring to FIG. 6A, the housing 600 of the electronic device according to an example embodiment may include a housing of a wearable electronic device. Hereinafter, a form of a watch housing 600 will be illustrated as the housing having a partitioning part. However, the housing according to an example embodiment may include a housing of various wearable devices, such as a necklace, a ring, or a buckle of a waistband, or the like, as well as a watch, but is not limited thereto.

The watch housing 600, for example, may include a left housing 600b, slit areas 610, and a right housing 600a.

The left housing 600b may include a housing corresponding to a left area of the watch housing 600 with respect to the slit areas 610. The right housing 600a may include a housing corresponding to a right area of the watch housing 600 with respect to the slit areas 610. The slit areas 610, for example, may include a first slit area 610a that is arranged on the upper side and a second slit area 610b that is arranged on the lower side. According to an embodiment, the first slit area 610a may include at least one slit 631, at least one slit filling part 651, and at least one rail part 632. The number of slits 631 (or the slit filling parts 651 or the rail parts 632) may be changed according to the type and form of a communication interface that is applied to the electronic device. The second slit area 610b may include a form that is vertically symmetrical with reference to the center of the watch housing 600. Although the drawing illustrates that the second slit area 610b has the same form as the first slit area 610a, the present disclosure is not limited thereto. For example, the width or number of the slits 631 of the first slit area 610a may be different from the width or number of the slits of the second area 610b. According to various embodiments, although it has been illustrated that the slit areas 610 are arranged in a vertical direction of the watch housing 600, the present disclosure is not limited thereto. For example, the slit areas 610 may be arranged transversely or diagonally with respect to the center of the watch housing 600. Further, the slit areas 610 may be arranged in a specific peripheral area of the watch housing 600.

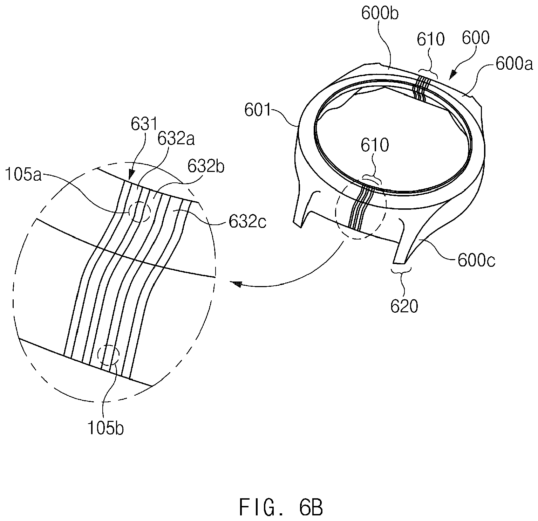

FIG. 6B is a diagram illustrating an example of an electronic device, to which a housing is applied, according to another example embodiment.

Referring to FIG. 6B, the slit areas 610 and 620 may be formed (for example, the slit area 610) in a bezel 601 (or a peripheral area) of the watch housing 600, or may be formed (for example, the slit area 620) in a connecting part 600c that is connected to a strap. According to various embodiments, the slit area 620 may include at least one slit 631 and at least one rail part 632a, 632b, and 632c in correspondence to a form of the connecting part 600c that extends in a first direction (for example, extends in a direction in which the slit area 620 deviates from the bezel 601). According to various example embodiments, the watch housing 600 may further include metal ribs 105a and 105b, each of which connects a pair of rail parts 632a, 632b, and 632c that are independently provided by the plurality of slits 631. According to an example embodiment, the slit area 610 that includes three rail parts 632a, 632b, and 632c may include a first metal rib 105a that connects an upper end of the first rail part 632a and an upper end of the second rail part 632b, and a second metal rib 105b that connects a lower end of the second rail part 632b and a lower end of the third rail part 632c. Accordingly, because the first rail part 632a, the second rail part 632b, and the third rail part 632c are provided to form a specific pattern, the slit area 610 may have a length related to management of an antenna of the communication interface. The number of the rail parts 632a, 632b, and 632c that are connected to each other through the metal ribs 105a and 105b and the like may be changed according to the type and operational frequency of the communication interface. The metal ribs 105a and 105b also may be formed in the slit area 620, and in this case, the metal ribs 105a and 105b may extend the lengths of the plurality of rail parts.

Meanwhile, the above-mentioned slit areas 610 and 620 may be configured such that the slit filling parts (for example, a resin) may be arranged in the slits 631, and bonding layers may be formed on the inner walls of the slits 631 (or the inner walls of the rail parts 632). Further, an inner structure (for example, a plastic structure) that is connected to the slit filling parts may be further included on the insides (for example, an inner wall on which the slit areas 610 and 620 are formed) of the slit areas 610 and 620. A bonding layer may be further formed between the inner structure and the slit filling part.

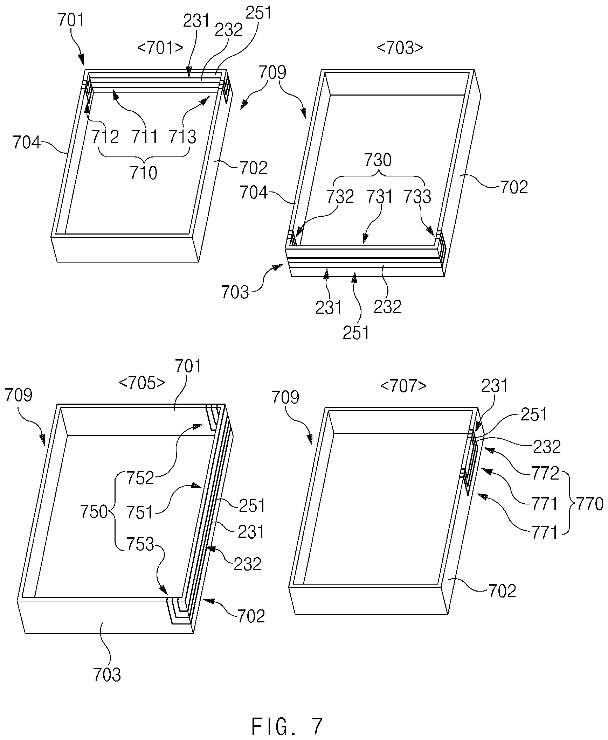

FIG. 7 is a diagram illustrating another example of forming a slit area of a housing of according to an example embodiment.

Referring to FIG. 7, as in state 701, the slit area 710 may include a slit 231, a rail part 232, and a slit filling part 251. The slit area 710 may include at least one first slit area 711 (or a slit and a rail part) that is arranged on a side wall 701 of an upper part of the housing in a lengthwise direction of the side wall 701, and a second slit area 712 and a third slit area 713 (or a slit and a rail part) that are formed in an area of left and right side walls 702 and 704 that is connected to the side wall 701 of the upper part of the housing to be bent from the side wall 701 by a specific angle. Additionally, at least one rib 105 may be arranged in the first slit area 711. The rib 105, for example, may be provided through partial grooving in a process of machining an inside of the side wall 701 of the upper part, in which the first slit area 711 is formed. The rib 105 may function to firmly support the rail parts 232 arranged in the slit area 710, and also may function to electrically connect the rail parts 232. The rail parts 232 included in the slit area 710 may be independently arranged such that at least one of the rail parts 232 are physically separated from a peripheral area by the second slit area 712 and the third slit area 713.

Further, as in state 703, the slit area 730 may include at least the side wall 703 of the lower part of the housing. For example, although the slit area 730, at least a portion of which is formed on the side wall 703 of a lower part of the housing, may be situated at a location that is different from a location of the slit area 701 formed on the side wall 701 of the upper part of the housing, but they may have the same or similar shapes. For example, the slit area 730 may include a first slit area 731 that includes a plurality of rail parts 232 arranged on the side wall 703 of the lower part of the housing in parallel to each other (or in a lengthwise direction of the side wall) and a slit 231, a second slit area 732 that extends from the first slit area 731, is situated on a side wall 704 (for example, the left side wall of the drawing), and is arranged such that the rail parts 232 of the slit area 730 are electrically isolated from the housing 709, and a third slit area 733 that is symmetrical to the second slit area 732 with respect to a longitudinal center line of the housing 709.

Further, as in state 705, the slit area 750 may be formed while the side wall of the intermediate part of the housing being the center thereof. For example, the slit area 750 may include a first slit area 751 that is formed on the side wall 702 of the intermediate part of the housing, a second slit area 752 that extends from one side of the first slit area 751 and is formed in a right corner area of the side wall 701 of the upper part of the housing, and a third slit area 753 that extends from an opposite side of the second slit area 200 and is formed at a right corner area of the side wall 703 of the lower part of the housing.

According to various example embodiments, as in state 707, the slit area 770 of the present disclosure, for example, may be formed in an area of the side wall 702 of the intermediate part of the housing to have a U shape. For example, the slit area 770 may include a first slit area 771 that has a specific length (for example, a length that is smaller than an entire length of the side wall 702 of the intermediate part of the housing) in a longitudinal direction of the side wall 702 of the intermediate part of the housing, a second slit area 772 that extends from the first slit area 771 and is formed at an upper end of the side wall 702 in the side wall 702 of the intermediate part of the housing, a third slit area 773 that extends from the first slit area 771 and is formed at an intermediate part or a lower end of the side wall 702 with respect to the slit area 771. The above-mentioned slit area 770 may be formed not to interfere with a physical button arranged on a side wall of the housing 709. Further, the slit area 770 may be arranged to be close to the upper end of the housing such that the slit area 770 does not overlap a grip area of the user, by which the user grips the electronic device.

According to various example embodiments, in state 701, state 703, state 705, and state 707, at least one metal rib may be included on the inside (the inside of the side wall 702 of the intermediate part of the housing) of the slit areas 710, 730, 750, and 770. Further, an inner structure (for example, a plastic structure formed based on a thermoplastic resin) may be arranged on the insides of the slit areas 710, 730, 750, and 770. A first bonding layer may be formed between the inner wall (or the inner wall of the rail part 232) of the slit 231 formed in the above-mentioned slit areas 710, 730, 750, and 770, and a second bonding layer may be formed between the inner structure and the inner wall of the housing. Accordingly, a second bonding layer may be arranged between the inner structure and the slit filling part 251. Further, the disclosed example embodiments are provided to describe the technical contents or for understanding of the technical contents, and the technical scope of the present disclosure is not limited thereto. Accordingly, the scope of the present disclosure should be construed to include all changes or various embodiments based on the technic of the present disclosure.

According to various example embodiments, various necessary antenna patterns may be acquired through the housing without increasing the thickness of the electronic device, and an appealing external appearance of the electronic device may be improved.

While the present disclosure has been illustrated and described with reference to various example embodiments thereof, it will be understood by those skilled in the art that various changes in form and details may be made therein without departing from the scope of the present disclosure as defined by the appended claims.

## Claims

1. An electronic device comprising:
a housing comprising a metal main body (110a) formed on a first surface, and at least one side wall (110b) formed at a periphery of the main body on a second surface different from the first surface;
a slit area (200) to be used as an antenna for performing a communication function, comprising a plurality of slits (231), formed on a surface of the at least one side wall (110b) of the housing and having a specific width and a specific length, at least a portion of each slit extending from an outer surface of the housing to an inner surface of the housing;
a plurality of metal rail parts (232) that are partitioned by the plurality of slits;
a slit filling part (210) filled in the interior of each of the plurality of slits;
an inner support structure (220) that is formed on the inner surface of the housing and is connected to at least a portion of the slit filling parts; and
at least one metal rib (105) that electrically connects the rail parts to a part of the housing, wherein each metal rib fixes the rail parts (232) to each other in an area partitioned by the slits (231),
wherein the specific length of the slit area (200) is smaller than an entire length of a side wall,
wherein the slit area (200) is formed to have a U shape on the surface of the at least one side wall (110b) of the housing.

2. The electronic device of claim 1, wherein the housing further comprises at least one of:
a first bonding layer (211) arranged between inner walls of the rails partitioned by the slits and the slit filling parts; a second bonding layer (221) arranged between an inner wall of the housing and the inner support structure or a second bonding layer arranged between the slit filling parts and the inner support structure.

3. The electronic device of claim 1, wherein the at least one metal rib comprises a plurality of metal ribs that connect the rail parts in a zigzag pattern.

4. The electronic device of claim 1, wherein a width of the slits is in a range of 0.01 mm to 1 mm,
wherein a depth of the slits is in a range of 0.1 mm to 6 mm, or
wherein a depth of the slits is in a range of 0.1 mm to 2 mm.

5. The electronic device of claim 1, wherein the electronic device is a watch and
wherein the slit area is formed on at least one of a bezel of the housing or one side of a connecting part of the housing connected to a strap of the housing.

6. A method of manufacturing a housing of an electronic device, the method comprising:
providing a metal housing comprising a main body (110a) formed on a first surface, and at least one side wall (110b) formed at a periphery of the main body on a second surface different from the first surface;
forming a plurality of slits (231) having a specific depth and a specific length on an outside surface of the at least one side wall (110b) of the housing;
filling each slit with a slit filling part (210) and forming a slit support part (450) connected to the slit filling parts and formed on at least one surface of the housing and having a specific thickness;
forming at least one recess (470) on an inner surface of the housing corresponding to an area in which the slits are formed such that at least a portion of the slits extends from an outer surface of the housing to an inner surface of the housing;
forming an inner support structure (490) on at least a portion of the inner surface of the housing comprising the recess; and
removing the slit support part;
wherein the forming of the recess comprises forming at least one metal rib (105) that connects rail parts (232) partitioned by the slits to a part of the housing, by partially forming the recess,
wherein the specific length of the slit area (200) is smaller than an entire length of a side wall,
wherein the slit area (200) is formed to have a U shape on the surface of the at least one side wall (110b) of the housing.

7. The method of claim 6, wherein the forming at least one metal rib comprises:
forming a plurality of metal ribs that connects the rail parts in a zigzag pattern.

8. The method of claim 6, further comprising: forming a first bonding layer on inner walls of the rail parts partitioned by the slits after the slits are formed.

9. The method of claim 6, further comprising: forming a second bonding layer on an inner wall of the housing after the recess is formed.

## Patentansprüche

1. Elektronische Vorrichtung, welche Folgendes umfasst:
ein Gehäuse, das einen Metallhauptkörper (110a) umfasst, der auf einer ersten Oberfläche gebildet ist, und mindestens eine Seitenwand (110b), die an einem Umfang des Hauptkörpers auf einer zweiten Oberfläche gebildet ist, die sich von der ersten Oberfläche unterscheidet;
einen Schlitzbereich (200), der als Antenne zum Durchführen einer Kommunikationsfunktion zu verwenden ist, der eine Vielzahl von Schlitzen (231) umfasst, die auf einer Oberfläche der mindestens einen Seitenwand (110b) des Gehäuses gebildet sind und eine spezifische Breite und eine spezifische Länge haben, wobei sich mindestens ein Teil eines jeden Schlitzes von einer Außenfläche des Gehäuses zu einer Innenfläche des Gehäuses erstreckt;
eine Vielzahl von Metallschienenteilen (232), die durch die Vielzahl von Schlitzen aufgeteilt sind;
einen Schlitzfüllteil (210), der in das Innere einer jeden der Vielzahl von Schlitzen gefüllt ist;
eine innere Tragstruktur (220), die auf der Innenfläche des Gehäuses gebildet ist und mit mindestens einem Teil der Schlitzfüllteile verbunden ist; und
mindestens eine Metallrippe (105), die die Schienenteile mit einem Teil des Gehäuses elektrisch verbindet, wobei jede Metallrippe die Schienenteile (232) in einem Bereich aneinander befestigt, der durch die Schlitze (231) aufgeteilt ist,
wobei die spezifische Länge des Schlitzbereichs (200) kleiner als eine gesamte Länge einer Seitenwand ist,
wobei der Schlitzbereich (200) so gebildet ist, dass er eine U-Form auf der Oberfläche der mindestens einen Seitenwand (110b) des Gehäuses hat.

2. Elektronische Vorrichtung nach Anspruch 1, wobei das Gehäuse des Weiteren mindestens eines von Folgendem umfasst:
eine erste Verbindungsschicht (211), die zwischen Innenwänden der Schienen angeordnet ist, die durch die Schlitze und die Schlitzfüllteile aufgeteilt sind; eine zweite Verbindungsschicht (221), die zwischen einer Innenwand des Gehäuses und der inneren Tragstruktur angeordnet ist oder eine zweite Verbindungsschicht, die zwischen den Schlitzfüllteilen und der inneren Tragstruktur angeordnet ist.

3. Elektronische Vorrichtung nach Anspruch 1, wobei die mindestens eine Metallrippe eine Vielzahl von Metallrippen umfasst, die die Schienenteile in einem Zickzackmuster verbinden.

4. Elektronische Vorrichtung nach Anspruch 1, wobei eine Breite der Schlitze in einem Bereich von 0,01 mm bis 1 mm liegt,
wobei eine Tiefe der Schlitze in einem Bereich von 0,1 mm bis 6 mm liegt, oder
wobei eine Tiefe der Schlitze in einem Bereich von 0,1 mm bis 2 mm liegt.

5. Elektronische Vorrichtung nach Anspruch 1, wobei die elektronische Vorrichtung eine Uhr ist und
wobei der Schlitzbereich auf einer Blende des Gehäuses und/oder einer Seite eines Verbindungsteils des Gehäuses gebildet ist, das mit einem Band des Gehäuses verbunden ist.

6. Verfahren zum Herstellen eines Gehäuses einer elektronischen Vorrichtung, wobei das Verfahren Folgendes umfasst:
Bereitstellen eines Metallgehäuses, das einen Hauptkörper (110a) umfasst, der auf einer ersten Oberfläche gebildet ist, und mindestens eine Seitenwand (110b), die an einem Umfang des Hauptkörpers auf einer zweiten Oberfläche gebildet ist, die sich von der ersten Oberfläche unterscheidet;
Bilden einer Vielzahl von Schlitzen (231), die eine spezifische Tiefe und eine spezifische Länge auf einer Außenfläche der mindestens einen Seitenwand (110b) des Gehäuses haben;
Füllen eines jeden Schlitzes mit einem Schlitzfüllteil (210) und Bilden eines Schlitzstützteils (450), das mit den Schlitzfüllteilen verbunden und auf mindestens einer Oberfläche des Gehäuses gebildet ist und eine spezifische Dicke hat;
Bilden mindestens einer Aussparung (470) auf einer Innenfläche des Gehäuses entsprechend einem Bereich, in dem die Schlitze so gebildet sind, dass sich mindestens ein Teil der Schlitze von einer Außenfläche des Gehäuses zu einer Innenfläche des Gehäuses erstreckt;
Bilden einer inneren Tragstruktur (490) auf mindestens einem Teil der Innenfläche des Gehäuses, das die Aussparung umfasst; und
Entfernen des Schlitzstützteils;
wobei das Bilden der Aussparung das Bilden mindestens einer Metallrippe (105) umfasst, die durch die Schlitze aufgeteilte Schienenteile (232) mit einem Teil des Gehäuses verbindet, indem die Aussparung teilweise gebildet wird,
wobei die spezifische Länge des Schlitzbereichs (200) kleiner als eine gesamte Länge einer Seitenwand ist,
wobei der Schlitzbereich (200) so gebildet ist, dass er eine U-Form auf der Oberfläche der mindestens einen Seitenwand (110b) des Gehäuses hat.

7. Verfahren nach Anspruch 6, wobei das Bilden mindestens einer Metallrippe Folgendes umfasst:
Bilden einer Vielzahl von Metallrippen, die die Schienenteile in einem Zickzackmuster verbindet.

8. Verfahren nach Anspruch 6, welches ferner umfasst:
Bilden einer ersten Verbindungsschicht an Innenwänden der Schienenteile, die durch die Schlitze aufgeteilt sind, nach dem Bilden der Schlitze.

9. Verfahren nach Anspruch 6, welches ferner umfasst:
Bilden einer zweiten Verbindungsschicht auf einer Innenwand des Gehäuses nach dem Bilden der Aussparung.

## Revendications

1. Dispositif électronique comprenant :
un boîtier comprenant un corps principal métallique (110a) formé sur une première surface, et au moins une paroi latérale (110b) formée à une périphérie du corps principal sur une deuxième surface différente de la première surface ;
une zone de fentes (200) à utiliser comme antenne pour effectuer une fonction de communication, comprenant une pluralité de fentes (231), formée sur une surface de l'au moins une paroi latérale (110b) du boîtier et ayant une largeur spécifique et une longueur spécifique, au moins une partie de chaque fente s'étendant d'une surface extérieure du boîtier à une surface intérieure du boîtier ;
une pluralité de parties de rail métalliques (232) qui sont cloisonnées par la pluralité de fentes ;
une partie de remplissage de fentes (210) remplie à l'intérieur de chacune de la pluralité de fentes ;
une structure de support intérieure (220) qui est formée sur la surface intérieure du boîtier et qui est connectée à au moins une partie des parties de remplissage de fentes ; et
au moins une nervure métallique (105) qui relie électriquement les parties de rail à une partie du boîtier, où chaque nervure métallique fixe les parties de rail (232) entre elles dans une zone cloisonnée par les fentes (231),
où la longueur spécifique de la zone de fentes (200) est inférieure à toute la longueur d'une paroi latérale,
où la zone de fentes (200) est formée de façon à avoir une forme en U sur la surface de l'au moins une paroi latérale (110b) du boîtier.

2. Dispositif électronique selon la revendication 1, où le boîtier comprend en outre au moins l'une parmi :
une première couche de liaison (211) disposée entre les parois intérieures des rails cloisonnés par les fentes et les parties de remplissage de fentes ; une deuxième couche de liaison (221) disposée entre une paroi intérieure du boîtier et la structure de support intérieure ou une deuxième couche de liaison disposée entre les parties de remplissage de fentes et la structure de support intérieure.

3. Dispositif électronique selon la revendication 1, où l'au moins une nervure métallique comprend une pluralité de nervures métalliques qui relient les parties de rail selon un motif en zigzag.

4. Dispositif électronique selon la revendication 1, où une largeur des fentes est dans une plage de 0,01 mm à 1 mm,
où la profondeur des fentes est dans une plage de 0,1 mm à 6 mm, ou
où la profondeur des fentes est dans une plage de 0,1 mm à 2 mm.

5. Dispositif électronique selon la revendication 1, où le dispositif électronique est une montre et
où la zone de fentes est formée sur au moins l'un parmi une lunette du boîtier ou un côté d'une partie de connexion du boîtier connectée à un bracelet du boîtier.

6. Procédé de fabrication d'un boîtier d'un dispositif électronique, le procédé comprenant :
fournir un boîtier métallique comprenant un corps principal (110a) formé sur une première surface, et au moins une paroi latérale (110b) formée à une périphérie du corps principal sur une deuxième surface différente de la première surface ;
former une pluralité de fentes (231) ayant une profondeur spécifique et une longueur spécifique sur une surface extérieure de l'au moins une paroi latérale (110b) du boîtier ;
remplir chaque fente avec une partie de remplissage de fentes (210) et former une partie de support de fentes (450) connectée aux parties de remplissage de fentes et formée sur au moins une surface du boîtier et ayant une épaisseur spécifique ;
former au moins un évidement (470) sur une surface intérieure du boîtier correspondant à une zone dans laquelle les fentes sont formées de telle sorte qu'au moins une partie des fentes s'étend d'une surface extérieure du boîtier à une surface intérieure du boîtier ;
former une structure de support intérieure (490) sur au moins une partie de la surface intérieure du boîtier comprenant l'évidement ; et
retirer la partie de support de fentes ;
où la formation de l'évidement comprend la formation d'au moins une nervure métallique (105) qui relie les parties de rail (232) séparées par les fentes à une partie du boîtier, en formant partiellement l'évidement,
où la longueur spécifique de la zone de fentes (200) est inférieure à toute la longueur d'une paroi latérale,
où la zone de fentes (200) est formée pour avoir une forme en U sur la surface de l'au moins une paroi latérale (110b) du boîtier.

7. Procédé selon la revendication 6, où la formation d'au moins une nervure métallique comprend :
former une pluralité de nervures métalliques qui relient les parties de rail selon un motif en zigzag.

8. Procédé selon la revendication 6, comprenant en outre :
former une première couche de liaison sur les parois intérieures des parties de rail séparées par les fentes après la formation des fentes.

9. Procédé selon la revendication 6, comprenant en outre :
former une deuxième couche de liaison sur une paroi intérieure du boîtier après la formation de l'évidement.
